# EUROPÄISCHE PATENTSCHRIFT

(11) **EP 2 394 077 B1**
(45) Veröffentlichungstag und Bekanntmachung des Hinweises auf die Patenterteilung: **28.11.2012**
(21) Anmeldenummer: 10708694.4
(22) Anmeldetag: 04.02.2010
(51) Int. Cl.: F16H 61/24, F16H 59/02, F16H 61/22

(54) **BETÄTIGUNGSEINRICHTUNG MIT FORCE FEEDBACK**
ACTUATION DEVICE HAVING FORCE FEEDBACK
DISPOSITIF DE COMMANDE A RETOUR DE FORCE

(30) Priorität: 05.02.2009 DE 102009000640
(43) Veröffentlichungstag der Anmeldung: 14.12.2011
(73) Patentinhaber: ZF Friedrichshafen AG, 88038 Friedrichshafen (DE)
(72) Erfinder: PEUKERT, Andreas, 49406 Barnstorf (DE)
(86) Internationale Anmeldenummer: PCT/DE2010/050003
(87) Internationale Veröffentlichungsnummer: WO 2010/088900

(56) Entgegenhaltungen:
- EP-A2- 1 182 381
- EP-A2- 1 220 068
- WO-A1-2009/138079
- DE-A1-102005 061 285
- JP-A- 4 092 151
- US-A1- 2004 011 152
- US-A1- 2005 247 154
- US-A1- 2006 283 279

## Beschreibung

Die Erfindung betrifft eine Betätigungseinrichtung für ein Gangwechselgetriebe, beispielsweise für ein Schaltgetriebe oder für einen Getriebeautomaten mit shift-by-wire-Betätigung, gemäß dem Oberbegriff des Patentanspruchs 1.

Gangwechselgetriebe von Kraftfahrzeugen werden im Allgemeinen mittels einer im Griffbereich des Fahrers angeordneten Betätigungseinrichtung geschaltet bzw. gesteuert. Regelmäßig kommen hierzu Betätigungselemente wie Schalthebel oder Wählhebel zum Einsatz, die beispielsweise zwischen den Frontsitzen des Kraftfahrzeugs oder in anderen Bereichen des Cockpits angeordnet sind.

Dabei wird aus Gründen der Ergonomie und Sicherheit insbesondere gefordert, dass dem Fahrer etwaige momentan nicht zulässige Schaltzustände, oder den Ablauf der angeforderten Schaltoperation, in Form entsprechender Schaltwiderstände bzw. Sperren am Betätigungshebel haptisch deutlich spürbar signalisiert werden. Nur auf diese Weise kann eine haptisch gestützte Schaltbetätigung realisiert werden, wie der Fahrer sie beispielsweise vom vollsynchronisierten mechanischen Schaltgetriebe mit dessen drehzahl- und geschwindigkeitsabhängigen Synchronsperren, oder auch von der konventionellen Betätigung eines Getriebeautomaten mit dessen Rastierung und dessen Schaltsperren kennt und gewohnt ist.

Daher ist es in jedem Fall erforderlich, dass dem Fahrer bei der Getriebebetätigung klare taktile Rückmeldungen über den aktuellen Schalt- oder Betriebszustand des Getriebes, bzw. über den Schalterfolg vermittelt werden.

Bei der elektrischen bzw. shift-by-wire-Betätigung von Gangwechselgetrieben existiert jedoch keine mechanische Kopplung mehr zwischen dem Betätigungshebel in der Fahrgastzelle und dem Kraftfahrzeuggetriebe im Motorraum. Vielmehr erfolgt die Übertragung der Schaltbefehle von der Betätigungseinrichtung zum Kraftfahrzeuggetriebe beim "shift-by-wire"-Getriebe mittels elektrischer oder elektronischer Signale und anschließender beispielsweise elektrohydraulischer Umsetzung der Schaltbefehle am Getriebe.

Die fehlende mechanische Verbindung zwischen der Getriebeaktuatorik und dem Betätigungshebel führt dabei jedoch dazu, dass der Getriebezustand, etwaige Getriebe-Schaltsperren oder unzulässige Schaltbefehle nicht mehr direkt und für den Fahrer spürbar auf den Zustand des Betätigungshebels rückwirken können.

Der Fahrer kann bei shift-by-wire-gesteuerten Getrieben somit nicht ohne weiteres anhand bestimmter am Betätigungshebel spürbar blockierter Schaltstellungen erkennen, dass Schalthebelstellungen, Fahrstufen bzw. Schaltbefehle im momentanen Fahrzustand eventuell nicht zulässig sind und somit auch nicht angewählt werden sollten. Ebensowenig wirkt im Fall der shift-by-wire-Betätigung die tatsächliche Ausführung der Schaltbefehle durch das Getriebe auf den Betätigungshebel zurück. Daher kann der Fahrer den Ablauf der Schaltbetätigung somit auch nicht haptisch spürbar wahrnehmen, wie er dies beispielsweise vom mechanisch betätigten Schaltgetriebe mit dessen Rastierung und Getriebe-Synchronsperren gewohnt ist.

In Abhängigkeit des Zustands des zu bedienenden Gangwechselgetriebes sowie in Abhängigkeit anderer Zustandsfaktoren am Kraftfahrzeug - z.B. Motordrehzahl, Fahrzeuggeschwindigkeit, Kupplungsstellung etc. - ist es zur Realisierung des erforderlichen haptischen Feedback bei shift-by-wire-gesteuerten Getrieben somit notwendig, die Bewegung des Betätigungshebels je nach Getriebezustand aktiv gesteuert zu begrenzen, zu verzögern oder allgemein aktuatorische Kräfte - im Sinne eines Force Feedback - in den Hebel einzuleiten.

Nur auf diese Weise kann dem Fahrer beim Griff nach dem Betätigungshebel auch bei einem shift-by-wire-gesteuerten Getriebe haptisch spürbar vermittelt werden, dass sein Schaltwunsch - beispielsweise aufgrund der aktuellen Geschwindigkeit des Kraftfahrzeugs bzw. aufgrund des momentanen Betriebszustands des Gangwechselgetriebes - nicht zulässig und damit gesperrt ist. Auch lässt sich somit vermeiden, dass vom shift-by-wire-Getriebe aktuell nicht umsetzbare Schaltbefehle, die von der Getriebe-Elektronikeinheit erkannt und somit nicht von der Betätigungseinrichtung an das Getriebe übermittelt werden, am Betätigungshebel dennoch eingelegt werden können.

Wie zum Beispiel aus der DE 10 2005 001 589 B3 hervorgeht, ist es aus dem Stand der Technik bekannt, die einem Betätigungselement mit mechanischer Kraftübertragung entsprechende Haptik bei einem shift-by-wire geschalteten Gangwechselgetriebe zu realisieren, indem das Betätigungselement mit einem elektronisch steuerbaren Sperraktuator versehen ist. Der Sperraktuator wird mittels einer Steuereinrichtung so angesteuert, dass momentan etwa unzulässige Schaltzustände haptisch spürbar blockiert sind und somit vom Fahrer nicht angewählt werden können.

Derartige Betätigungseinrichtungen mit Sperraktuatoren sind bezüglich der Umsetzung eines realistischen Haptikerlebnisses jedoch noch nicht optimal, da der Betätigungshebel mittels des Sperraktuators lediglich entweder komplett gesperrt oder komplett freigegeben werden kann. Eine darüber hinausgehende, realistischere Haptik, die einer mechanischen Kraftübertragung zum Gangwechselgetriebe - insbesondere bezüglich des Kraftfeedbacks - besser entspricht, lässt sich durch den bekannten Einsatz von Sperraktuatoren nicht erreichen. Dem Fahrer wird am Schalthebel haptisch lediglich vermittelt, dass der Schalthebel entweder frei beweglich ist (Sperraktuator deaktiviert), oder dass bestimmte Schaltstellungen komplett gesperrt sind (Sperraktuator aktiviert).

Insbesondere aber lässt sich eine allmähliche (mit dem Bewegungsweg zunehmende), haptische Signalisierung einer aktuell bestehenden Sperrung einer bestimmten Schaltposition - in Abhängigkeit des durch die Hand des Fahrers am Schalthebel zurückgelegten Weges - mit den bekannten Sperraktuatoren nicht erzielen, da diese nur zwei Zustände kennen, nämlich "Betätigungsstellung gesperrt" oder "Betätigungsstellung freigegeben".

Aus dem Stand der Technik bekannte Betätigungseinrichtungen mit Force Feedback andererseits sind häufig nachteilig insofern, als die zur Realisierung des Force Feedback erforderlichen Komponenten grundsätzlich als zusätzliche Baugruppe im Bereich des Betätigungshebels, bzw. im Gehäuse der Betätigungseinrichtung untergebracht werden müssen. Dies führt zu zusätzlichem konstruktivem Aufwand und benötigt separaten Bauraum, der bei den zunehmend kleiner werdenden Betätigungselementen für moderne Kraftfahrzeuggetriebe oftmals nicht zur Verfügung steht. Zudem benötigen bekannte Force-Feedback-Einrichtungen stets einen eigenen aktuatorischen Antrieb, der neben dem zusätzlichen Platzbedarf auch zusätzlichen Energieverbrauch und damit verbundene Wärmeentwicklung bedeutet.

Mit diesem Hintergrund ist es Aufgabe der vorliegenden Erfindung, eine Betätigungseinrichtung mit einem Betätigungselement zu schaffen - insbesondere zur elektrischen bzw. elektronischen shift-by-wire-Betätigung eines Gangwechselgetriebes - mit der sich die genannten Nachteile des Standes der Technik überwinden lassen. Die Betätigungseinrichtung soll dabei insbesondere platzsparend, konstruktiv einfach und damit kostengünstig darstellbar sein, und es soll eine zuverlässige und realistische haptische Signalisierung von Schaltvorgängen bzw. gesperrten Betätigungspositionen erzielt werden.

Diese Aufgabe wird durch eine Betätigungseinrichtung mit den Merkmalen des Patentanspruchs 1 gelöst.

Bevorzugte Ausführungsformen sind Gegenstand der Unteransprüche.

In für sich genommen zunächst bekannter Weise umfasst die Betätigungseinrichtung gemäß der vorliegenden Erfindung einen Schaltsockel sowie ein Betätigungselement, beispielsweise einen Betätigungshebel, wobei das Betätigungselement um eine am Schaltsockel angeordnete Lagerstelle dreh- bzw. schwenkbar ist. In an sich ebenfalls bekannter Weise umfasst die Betätigungseinrichtung ferner einen Aktuator, der zur aktuatorischen Sperrung des Betätigungselements in einer oder mehreren Schaltpositionen dient.

Erfindungsgemäß zeichnet sich die Betätigungseinrichtung jedoch dadurch aus, dass der Aktuator - zusätzlich zu seiner Blockierungsfunktion bezüglich des Betätigungselements - zur Erzeugung mechanischer Schwingungen oder Vibrationen eingerichtet ist.

Auf diese Weise kann der Aktuator Schwingungen oder Vibrationen erzeugen, welche sich sodann über den Schaltsockel und die Lagerung auf das Betätigungselement bzw. auf den Wählhebel übertragen, und somit vom Fahrer bei der Betätigung des Wählhebels haptisch wahrgenommen werden können. Dem Fahrer kann somit insbesondere bereits beim Versuch einer Bewegung des Wählhebels in Richtung einer momentan unzulässigen Schaltstellung - mittels der durch den Aktuator erzeugten Vibrationen - haptisch signalisiert werden, dass er im Begriff ist, eine unzulässige oder im derzeitigen Betriebszustand des Gangwechselgetriebes nicht ausführbare Schaltoperation einzuleiten.

Der erfindungsgemäß entscheidende Vorteil besteht somit darin, dass zur Verwirklichung eines aktiven Force Feedback kein zusätzlicher aktuatorischer Antrieb, und überdies nicht einmal eine nennenswerte Modifikation der Betätigungseinrichtung notwendig ist. Stattdessen können dank der Erfindung auch bereits vorhandene Sperraktuatoren nahezu beliebiger Ausprägung in einer derartigen Doppelfunktion - bezüglich der Sperrung des Betätigungselements einerseits und der Erzeugung von Force Feedback andererseits - eingesetzt werden.

Eine vorhandene Betätigungseinrichtung muss dank der Erfindung somit nicht (oder nur minimal) umkonstruiert werden, um mit dem erfindungsgemäßen, proaktiven Force Feedback ausgestattet zu werden. Es ist dank der Erfindung sogar möglich, vorhandene oder auch bereits eingebaute Betätigungseinrichtungen ohne Force Feedback - lediglich mittels eines Softwareupdates - mit einer Force Feedback-Funktionalität auszustatten

Die Erfindung lässt sich zunächst einmal unabhängig davon verwirklichen, wie der Aktuator konstruktiv ausgebildet und angeordnet ist, solange der Aktuator sich bei geeigneter Ansteuerung zur Erzeugung von Vibrationen oder Schwingungen eignet. Gemäß einer besonders bevorzugten Ausführungsform der Erfindung ist der Aktuator jedoch durch einen Elektromagneten gebildet. Ein elektromagnetischer Aktuator ist zunächst einmal platzsparend und zuverlässig, und lässt sich mit geringem Energieverbrauch realisieren. Bezüglich der Erfindung ist ein elektromagnetischer Aktuator insofern vorteilhaft, als sich hiermit Schwingungen bzw. Vibrationen auf einfache Weise dadurch erzeugen lassen, dass der Aktuator mit Wechselstrom oder pulsierendem Gleichstrom angesteuert wird.

Mit diesem Hintergrund ist es gemäß einer weiteren bevorzugten Ausführungsform der Erfindung vorgesehen, dass die Ansteuerung des Aktuators mittels Pulsweitenmodulation erfolgt.

Ein pulsweitenmoduliertes Signal lässt sich mit geringem schaltungsmäßigem Aufwand und ohne nennenswerte schaltungstechnische Verlustwärme erzeugen. Zudem lässt sich so eine breite Vielfalt von Signalformen und -Frequenzen realisieren. Überdies kann dem pulsweitenmodulierten Signal ein weiteres Signal mit niedrigerer Frequenz aufmoduliert werden, so dass hierdurch charakteristische, ggf. auch unterschiedliche Signalformen erzeugt werden können, die dem Fahrer entsprechend charakteristische und ggf. voneinander unterscheidbare haptische Signale übermitteln. Beispielsweise kann einer momentan komplett gesperrten Schaltposition (z.B. dem Rückwärtsgang bei schneller Vorwärtsfahrt) ein anderes Vibrationsmuster zugeordnet werden als einer Schaltposition, die momentan zwar zulässig wäre, aber zu einem erhöhten Kraftstoffverbrauch führen würde (beispielsweise eine Gangposition mit überhöhter Motordrehzahl).

Gemäß einer weiteren Ausführungsform der Erfindung umfasst die Betätigungseinrichtung zumindest zwei Aktuatoren. Dabei wird der jeweils nicht zur aktuatorischen Blockierung des Wählhebels verwendete Aktuator zur Erzeugung der mechanischen Schwingungen oder Vibrationen herangezogen.

Auf diese Weise kann eine zuverlässige Erzeugung von Schwingungen oder Vibrationen und deren Übertragung auf das Betätigungselement auch dann erfolgen, wenn bereits einer der Aktuatoren - beispielsweise zur Sperrung einer momentanen nicht zulässigen Schaltposition des Betätigungselements bzw. Wählhebels - benötigt wird und damit nicht ohne weiteres gleichzeitig noch die gewünschten Schwingungen oder Vibrationen erzeugen kann. Dies gilt insbesondere dann, wenn der Bediener bzw. Fahrer verhältnismäßig stark gegen eine durch einen Aktuator momentan gebildete Schaltsperre drückt. Hierdurch könnte - beispielsweise im Fall eines elektromagnetischen Aktuators - dessen Anker vorübergehend verkanten und blockiert werden, so dass die Erzeugung von Schwingungen oder Vibrationen durch diesen Aktuator momentan unterbunden wäre. In diesem Fall kann somit der zweite, momentan jeweils nicht für eine Sperrfunktion herangezogene Aktuator zur zuverlässigen Erzeugung der Schwingungen bzw. Vibrationen herangezogen werden.

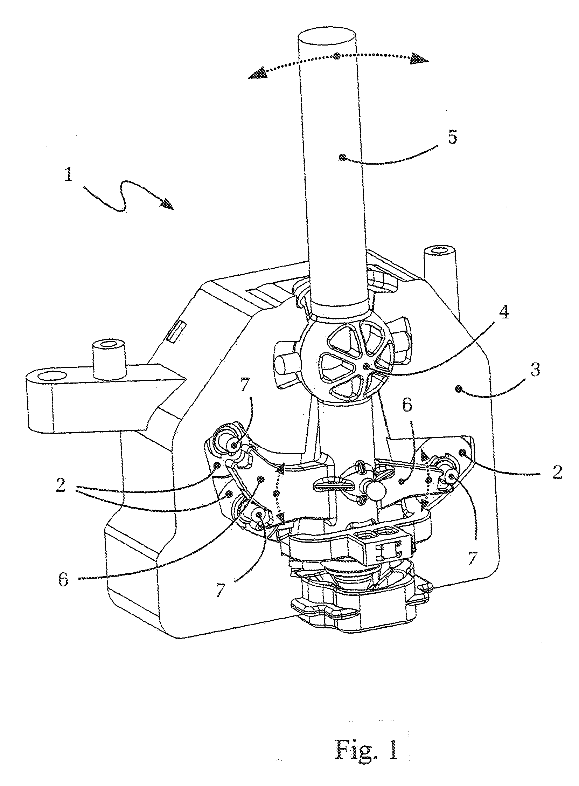

Im Folgenden wird die Erfindung anhand einer - lediglich ein Ausführungsbeispiel darstellenden - Zeichnung näher erläutert. Dabei zeigt die einzige Figur
- Fig. 1: in dieser Darstellung eine Ausführungsform der Betätigungseinrichtung gemäß der vorliegenden Erfindung.

Die **Fig.1** zeigt eine Betätigungseinrichtung 1 mit drei Sperraktuatoren 2 in einer für sich genommen zunächst bekannten Bauart.

Man erkennt in der **Fig.1** ferner einen - beispielsweise mit dem Karosserieboden des Kraftfahrzeugs verbindbaren - Schaltsockel 3, dessen eine Gehäusehälfte zur Erkennbarkeit des Innenlebens der Betätigungseinrichtung 1 in der Darstellung der **Fig.1** entfernt wurde. Mit dem Schaltsockel 3 ist mittels eines Kugelgelenks 4 ein Betätigungshebel 5 verbunden, der sich entlang des punktiert dargestellten Doppelpfeils in Fahrtrichtung nach vorne bzw. nach hinten bewegen lässt.

Ebenfalls im Schaltsockel 3 angeordnet sind insgesamt drei elektromagnetische Aktuatoren 2, welche jeweils mit Sperrfortsätzen 6 interagieren können, wobei die Sperrfortsätze 6 hier einstückig mit dem Betätigungshebel 5 ausgebildet sind. In Abhängigkeit von der Ansteuerung der drei elektromagnetischen Aktuatoren 2 wird somit eine entsprechende Anzahl an Ankerstiften 7 der Aktuatoren 2 ausgefahren und der Bewegungswinkel des jeweiligen Sperrfortsatzes 6 (und damit auch des Betätigungshebels) wird dementsprechend eingeschränkt bzw. reduziert. Auf diese Weise lassen sich somit bestimmte Schaltpositionen bzw. Schaltwinkelbereiche des Betätigungshebels 5 - mittels entsprechender Ansteuerung der Aktuatoren 2 - selektiv sperren.

Erfindungsgemäß erfolgt jedoch eine zusätzliche Ansteuerung einer oder mehrerer der Aktuatoren 2 dergestalt, dass die Aktuatoren 2 entweder mit Wechselstrom geeigneter Amplitude und Frequenz, oder mit pulsierendem Gleichstrom, insbesondere in Form von Pulsweitenmodulation, beaufschlagt werden.

Auf diese Weise werden somit in einem oder mehreren der Aktuatoren 2 entsprechende Schwingungen bzw. Vibrationen erzeugt, welche sich über den Schaltsockel 3 der Betätigungseinrichtung 1 und über das Kugelgelenk 4 auf den Wählhebel 5 fortpflanzen.

Dies bedeutet mit anderen Worten, dass die dargestellte Betätigungseinrichtung 1 - die für sich genommen in ihrer bekannten Form zunächst einmal kein Force Feedback bietet, welches über die reine Blockierung unzulässige Schaltstellungen hinausgeht - praktisch ohne jede konstruktive Änderung in eine Betätigungseinrichtung mit einer umfassenden, proaktiven oder variablen Force-Feedback-Funktionalität verwandelt werden kann. Dies kann im einfachsten Fall ggf. sogar in Form lediglich eines Softwareupdates erfolgen, welches in die Ansteuerschaltung der Betätigungseinrichtung 1 für die Aktuatoren 2 eingespielt wird.

Im Ergebnis wird damit deutlich, dass mit der Erfindung eine Betätigungseinrichtung mit Force-Feedback insbesondere für shift-by-wire-betätigte Gangwechselgetriebe geschaffen wird, die mit minimalem konstruktivem Aufwand ermöglicht, dass das haptischen Feedback für den Bediener bzw. Fahrer entscheidend verbessert werden kann, insbesondere indem eine flexible haptische Signalisierung von Schaltvorgängen oder gesperrten Betätigungspositionen erfolgt. Hierdurch wird es möglich, die Haptik und die Bewegungseigenschaften einer Betätigungseinrichtung für ein Gangwechselgetriebe - auch rein softwareseitig - in weitem Umfang zu verändern und an die spezifische Anwendung bzw. an die Nutzerpräferenzen anzupassen.

Die Erfindung leistet somit einen wichtigen Beitrag zur Verbesserung der Ergonomie, des Bedienkomforts und der Kosteneffektivität, insbesondere bei Anwendungen im Bereich der shift-by-wire-gesteuerten Getriebebetätigung von Kraftfahrzeugen.

### Bezugszeichenliste

- 1: Betätigungseinrichtung
- 2: Magnetaktuator
- 3: Schaltsockel
- 4: Kugelgelenk
- 5: Schalthebel, Wählhebel
- 6: Sperrfortsatz
- 7: Magnetanker

## Patentansprüche

1. Betätigungseinrichtung (1) zur Auswahl von Schaltstufen eines shift-by-wire-Gangwechselgetriebes, die Betätigungseinrichtung (1) umfassend einen Schaltsockel (3), ein in einer Lagerstelle (4) des Schaltsockels (3) dreh-oder schwenkbar gelagertes mechanisches Betätigungselement (5, 6) sowie zumindest einen Aktuator (2) mit einem Ankerelement (7), welches zwischen einem aktivierten Zustand, in welchem das Betätigungselement (5, 6) durch Anschlag am Ankerelement (7) entlang einer Betätigungsrichtung blockierbar ist, und einem deaktivierten Zustand, in welchem das Betätigungselement (5, 6) entlang der einen Betätigungsrichtung am Ankerelement (7) vorbei bewegbar ist, hin und her bewegbar ist, **dadurch gekennzeichnet, dass** der Aktuator (2) zusätzlich zu seiner Bewegungsfunktion für das Ankerelement (7) zur Erzeugung mechanischer Schwingungen oder Vibrationen eingerichtet ist.

2. Betätigungseinrichtung nach Anspruch 1, **dadurch gekennzeichnet, dass** der Aktuator (2) durch einen Elektromagneten gebildet ist.

3. Betätigungseinrichtung nach Anspruch 1 oder 2, **dadurch gekennzeichnet, dass** die Ansteuerung des Aktuators (2) in Form eines pulsweitenmodulierten Signals ausgebildet ist.

4. Betätigungseinrichtung nach einem der Ansprüche 1 bis 3, **dadurch gekennzeichnet, dass** die Betätigungseinrichtung (1) zumindest zwei Aktuatoren (2) umfasst, wobei der jeweils nicht zur Blockierung des Betätigungselementes (5, 6) verwendete Aktuator (2) zur Erzeugung der mechanischen Schwingungen oder Vibrationen herangezogen wird.

## Claims

1. Actuating device (1) for selecting shift stages of a shift-by-wire gear change transmission, the actuating device (1) comprising a shift base (3), a mechanical actuating element (5, 6) which is mounted in a rotatable or pivotable manner at a bearing point (4) of the shift base (3), and at least one actuator (2) with an armature element (7) which can be moved back and forth between an activated state, in which the actuating element (5, 6) can be blocked along an actuation direction by abutment against the armature element (7), and a deactivated state, in which the actuating element (5, 6) can be moved along the actuation direction past the armature element (7), **characterized in that** the actuator (2) is designed so as to generate mechanical oscillations or vibrations in addition to its movement function for the armature element (7).

2. Actuating device according to Claim 1, **characterized in that** the actuator (2) is formed by an electromagnet.

3. Actuating device according to Claim 1 or 2, **characterized in that** the drive of the actuator (2) is implemented in the form of a pulse-width-modulated signal.

4. Actuating device according to one of Claims 1 to 3, **characterized in that** the actuating device (1) comprises at least two actuators (2), wherein in each case the actuator (2) not used for blocking the actuating element (5, 6) is used for generating the mechanical oscillations or vibrations.

## Revendications

1. Dispositif de commande (1) pour la sélection d'étages de commutation d'une boîte de vitesses à changement de vitesse à commande électrique, le dispositif de commande (1) comprenant un socle de changement de vitesse (3), un élément de commande (5, 6) mécanique monté de manière rotative ou pivotante dans un point d'appui (4) du socle de changement de vitesse (3) ainsi qu'au moins un actionneur (2) muni d'un élément d'armature (7), qui peut être déplacé en alternance entre un état activé dans lequel l'élément de commande (5, 6) peut être bloqué par butée contre l'élément d'armature (7) le long d'une direction de commande, et un état désactivé dans lequel l'élément de commande (5, 6) peut être déplacé le long d'une direction de commande devant l'élément d'armature (7), **caractérisé en ce que** l'actionneur (2) est prévu, en plus de sa fonction de déplacement pour l'élément d'armature (7), pour produire des oscillations ou des vibrations mécaniques.

2. Dispositif de commande selon la revendication 1, **caractérisé en ce que** l'actionneur (2) est formé par un électroaimant.

3. Dispositif de commande selon la revendication 1 ou 2, **caractérisé en ce que** la commande de l'actionneur (2) est réalisée sous la forme d'un signal à modulation de largeur d'impulsion.

4. Dispositif de commande selon l'une quelconque des revendications 1 à 3, **caractérisé en ce que** le dispositif de commande (1) comprend au moins deux actionneurs (2), l'actionneur respectif (2) qui n'est pas utilisé pour bloquer l'élément de commande (5, 6) étant utilisé pour produire les oscillations ou les vibrations mécaniques.
